(19) **Europäisches Patentamt / European Patent Office / Office européen des brevets**

(11) **EP 2 676 370 B1**

(12) ## EUROPEAN PATENT SPECIFICATION

(45) Date of publication and mention of the grant of the patent:
**04.07.2018 Bulletin 2018/27**

(21) Application number: **11754553.3**

(22) Date of filing: **18.02.2011**

(51) Int Cl.:
**H03K 17/082** (2006.01)

(86) International application number:
**PCT/RU2011/000108**

(87) International publication number:
**WO 2012/112067 (23.08.2012 Gazette 2012/34)**

(54) **OVERCURRENT PROTECTION DEVICE AND METHOD OF OPERATING A POWER SWITCH**

ÜBERSTROMSCHUTZVORRICHTUNG UND VERFAHREN ZUM BETRIEB EINES LEISTUNGSSCHALTERS

DISPOSITIF DE PROTECTION CONTRE LES SURCHARGES ET PROCÉDÉ DE FONCTIONNEMENT D'UN COMMUTATEUR D'ALIMENTATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**25.12.2013 Bulletin 2013/52**

(73) Proprietor: **NXP USA, Inc.**
**Austin TX 78735 (US)**

(72) Inventors:
- **GUILLOT, Laurent**
  **F-31600 Seysses (FR)**
- **ROSADO, Philippe**
  **F-31470 Fonsorbes (FR)**
- **SHUVALOV, Denis Sergeevich**
  **Zelenograd 124482 (RU)**

- **SOLDATOV, Alexander Petrovich**
  **Zelenograd 124575 (RU)**
- **SYNGAEVSKIY, Vasily Alekseyevich**
  **Moscow 121359 (RU)**

(74) Representative: **Miles, John Richard**
**NXP SEMICONDUCTORS**
**Intellectual Property Group**
**Abbey House**
**25 Clarendon Road**
**Redhill, Surrey RH1 1QZ (GB)**

(56) References cited:
| | |
|---|---|
| WO-A1-2010/012323 | US-A- 5 898 557 |
| US-A1- 2003 072 120 | US-A1- 2008 100 978 |
| US-A1- 2009 167 272 | US-B1- 7 639 067 |

## Description

Field of the invention

This invention relates to an overcurrent protection device and a method of operating a power switch.

Background of the invention

An electric device may comprise a protective mechanism for protecting the device against high electric currents. Such currents may arise, for example, in the event of a short circuit, accident or other kind of failure. The protective mechanism may be arranged to interrupt an electric circuit in which an overcurrent has been detected. An overcurrent is an electric current that is greater than a maximum allowed current. A simple example of a protective mechanism is a fuse that is blown when the electric current through the fuse exceeds a maximum allowed current. Electronic protective mechanisms also exist.

Defining the maximum allowed current for a given application can be challenging because some electric devices may draw a large current when first turned on and a considerably lower stationary current after conductors in the device have heated up. This phenomenon is usually due to the fact that the electric resistance of a conductor usually increases as the temperature of the conductor increases.

For example, the electric device to be protected may be an incandescent lamp. The incandescent lamp may for example be a halogen lamp. Before the lamp is turned on, the temperature and thus the resistance of the lamp's filament may initially be very low. At turn-on, the temperature of the filament may start to rise from the ambient temperature. As the initial resistance may initially be low, a large initial current may occur when the lamp is turned on. A large initial current into a load upon turn-on is referred to as an inrush current. An inrush current may be many times (e.g. ten times) greater than a nominal current. The nominal current may be defined as the current through the load when the load has reached a stationary temperature. The expressions nominal current, stationary current and steady state current may be interchangeable. Both the inrush current and the steady state current may depend on the voltage applied at the lamp. The voltage applied at the lamp may in turn be a function of a supply voltage provided by e.g. a battery. A protective mechanism should allow the inrush current to flow in the load, e.g. in the wiring harness, but only for a specified time, e.g. not longer than one hundred milliseconds after switching the lamp on.

International patent application publication WO 2006/111187 A1 (Turpin) describes a current driver circuit having a current limit that is continuously or intermittently adjusted.

U.S. patent application publication US 2003/072120 A1 by Ishikawa discloses a load driving device for controlling a semiconductor device or switch, for controlling electrical power provided to a load. The load driving device comprises circuitry for providing overcurrent protection. A threshold determination circuit defines an overcurrent restriction threshold. A current restriction circuit detects whether the current through the load (load current) is larger than the overcurrent restriction threshold, and controls a switch accordingly. The overcurrent restriction threshold allows for a relatively large inrush current when the load driving starts and then gradually decreases as a function of time. The overcurrent restriction threshold is represented by a threshold voltage generated by voltage division of the supply voltage.

WO 2010/012323 A1 discloses a method for driving a bulb, in particular an incandescent bulb, by a semiconductor switch. Thereby, the drive strategy allows to control the energy provided to the bulb as well as the switch in order to minimize the stress inside the semiconductor switch in case of overload conditions.

Summary of the invention

The present invention provides an overcurrent protection device and a method of operating a power switch as described in the accompanying claims.

Specific embodiments of the invention are set forth in the dependent claims.

These and other aspects of the invention will be apparent from and elucidated with reference to the embodiments described hereinafter.

Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.

Figure 1 shows a schematic plot of a current through an example load as a function of temperature, for different amplitudes of a voltage applied to the load.
Figure 2 schematically shows an example of an embodiment of an overcurrent protection device.
Figure 3 shows a schematic plot of a first current, a second current and a maximum allowed current as functions of time, according to an example of an embodiment.
Figure 4 schematically shows an example of an embodiment of an overcurrent protection device.
Figure 5 shows a schematic plot of a pulse width modulated (PWM) signal, a turn-on detection signal, and a maximum allowed current signal according to an example of an embodiment.
Figure 6 schematically shows an example of an embodiment of a maximum-allowed-current unit.

Figure 7 shows a schematic flow chart of an example of a method of operating a power switch.

Figure 8 shows a schematic plot of a first maximum allowed current profile and a second maximum allowed current profile, according to an example of an embodiment.

Detailed description of the preferred embodiments

Because the illustrated embodiments of the present invention may for the most part be implemented using electronic components and circuits known to those skilled in the art, details will not be explained in any greater extent than that considered necessary as illustrated above, for the understanding and appreciation of the underlying concepts of the present invention and in order not to obfuscate or distract from the teachings of the present invention.

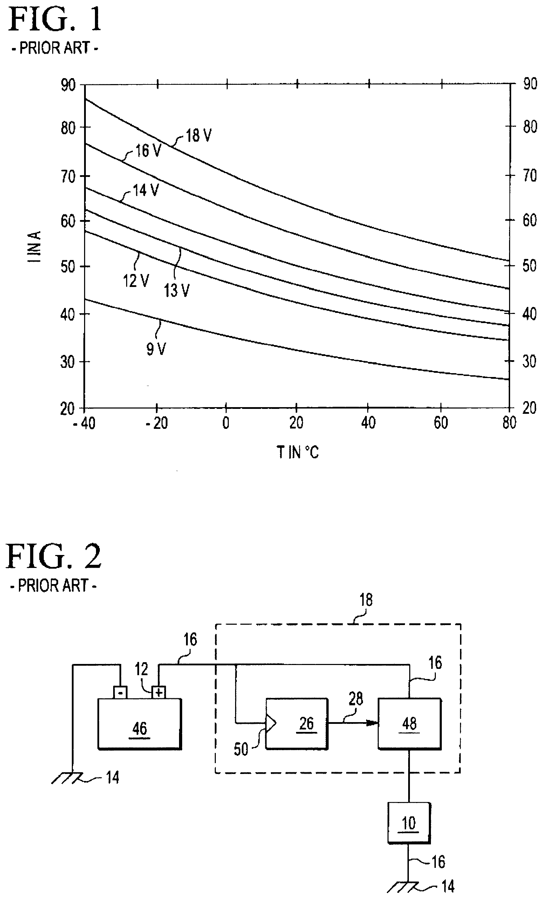

Figure 1 illustrates, by way of example, an electric current I that flows through a load when a voltage is applied at the load, as a function of a temperature T of the load. At any given temperature T, the current I may be an increasing function of the applied voltage V. For example, the current I may be related to the applied voltage V according to Ohm's law as $V = R * I$ where R is the resistance of the load. In the figure, the current I in ampere (A) is plotted versus the temperature T in degrees Celsius (°C), for six different stationary values of the applied voltage, namely, 9 V, 12 V, 13 V, 14 V, 16 V and 18 V. The load may for example be an incandescent lamp. In the plot, the resulting current I is seen to be a decreasing function of the temperature T for each of the indicated voltage values. For example, the current I observed with an applied voltage of 18 V drops from about 86 A at a temperature of minus 40 °C to about 51 A at a temperature of 80 °C. Of course, these values relate to a specific example of a load and may differ for a different load.

The plot may be representative of the most common case, namely the case in which the resistance of the load, and hence the current I, decreases smoothly with the temperature T. It is pointed out, however, that the present disclosure is not restricted to this case but may also be applicable to loads having a resistance that depends on the temperature in an abnormal manner.

Figure 2 illustrates in a schematic and simplified manner an example of an embodiment of an overcurrent protection device 18. In the example, a load 10 is coupled between a first voltage provider 12 and a second voltage provider 14, for example via a conductor 16. The load 10 may for example be an incandescent lamp, a cathode wire, a semiconductor device, or any other kind of electric load. The first voltage provider and the second voltage provider may for example be terminals of a voltage source. The voltage source may for example be a battery, a fuel cell, a fuel cell stack, a solar cell or an assembly of solar cells, or any other kind of voltage supply. In the present example, the second voltage provider 14 is a ground potential (ground). In the example, the overcurrent protection device 18 is coupled between the first terminal 12 and the load 10. The overcurrent protection device 18 may be operable to connect and disconnect the load 10 from one or both of the first and second voltage providers 12, 14. In the example, the overcurrent protection device 18 is operable to disconnect the load 10 from the first voltage provider 12. For example, the overcurrent protection device 18 may complete and, alternatively, interrupt the conductor 16 so as to couple/decouple the load 10 to/from the power supply. The overcurrent protection device 18, according to the present example embodiment, may comprise a switch unit 48 and a pulse width modulation unit (PWM) unit 26. The switch unit 48 may for example be a smart switch, e.g. an eXtreme switch. The PWM unit 26 may be operable to generate a pulse width modulated signal (PWM) control signal 28. The switch unit 48 may be operable to be controlled via the PWM control signal 28. For example, switch unit 48 may connect the load 10 to the supply voltage (in the present example, to the first voltage provider 12) in response to the PWM control signal 28 indicating a first state and to disconnect the load 10 from the supply voltage in response to the PWM control signal indicating a second state. The first state and the second state may for example be indicated respectively by a high voltage level and a low voltage level, or vice versa, output by the PWM unit 26. The PWM control signal 28 may have a duty cycle in the range of zero to one. The duty cycle may be the duration of a first interval divided by the combined duration of a first and second interval, wherein the first interval may be the interval during which the PWM control signal 28 indicates the first state and the second interval may be a subsequent interval during which the PWM control signal 28 indicates the second state. The duty cycle of the PWM control signal 28 may thus be proportional to an average voltage applied at the load 10. In the present example, the PWM unit 26 may be operable to set the duty cycle of the PWM control signal 28 according to the supply voltage, i.e. according to the voltage between the first voltage provider 12 and the second voltage provider 14. The PWM unit 26 may thus be operable to compensate for variations in the supply voltage by varying the duty cycle of the PWM control signal 28 may thus be proportional to an average voltage applied at the load 10.

In the present example, the PWM unit 26 may be operable to set the duty cycle of the PWM control signal 28 according to the supply voltage, i.e. according to the voltage between the first voltage provider 12 and the second voltage provider 14. The PWM unit 26 may thus be operable to compensate for variations in the supply voltage by varying the duty cycle of the PWM control signal 28. It may thus be ensured that the power consumed by the load 10 is constant when averaged over one cycle of the PWM control signal 28. More specifically, the PWM unit 26 may set the duty cycle such that the product *V remains constant, where V is the supply voltage. Thus, the PWM unit 26 may be operable to sense the supply voltage and control the load 10 accordingly.

The PWM unit 26 may, for example, be a microcontroller unit (MCU). In the shown example, the PWM unit 26 may comprise an analogue-to-digital converter 50 for generating a digital value indicative of the supply voltage. The PWM unit 26 may thus be operable to set the duty cycle of the PWM control signal 28 according to said digital value.

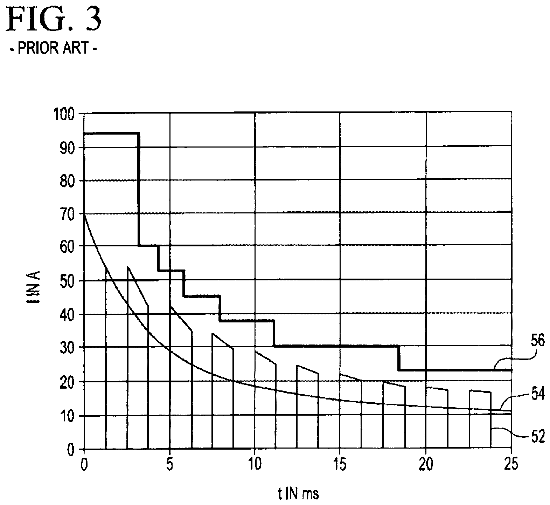

The switch unit 48 may be operable to disconnect the load 10 from the supply voltage in response to an indication that a current through the load 10 is exceeding a maximum allowed current. The maximum allowed current may be defined as a function of time as illustrated further by way of example only with reference to Figure 3. For example, the switch unit 48 may sense a current through the load 10 and check whether the sensed current does not exceed the maximum allowed current.

Schematically plotted in Figure 3 is a first current 52, a second current 54, and a maximum allowed current 56, as functions of a time t. The first current 52 may be a current through e.g. the load 10 (see Figure 2) when the PWM control signal 28 has a duty cycle of e.g. 50%. The second current 54 may be observed e.g. in the load 10 (see Figure 2) when the PWM control signal 28 has a duty cycle of 1, i.e. when the PWM control signal is continuous. The first current 52 is, therefore, discontinuous, whereas the second current 54 is continuous with respect to time t. The maximum allowed current may for example be defined according to an expected inrush current. More specifically, the maximum allowed current 56 may be defined so as to permit an expected inrush current to flow through the load 10. The maximum allowed current 56 may thus be greater than the expected inrush current for any point in time t. In the example, the maximum allowed current 56 is a decreasing function of time. A function $F(X)$ is called decreasing if X2 being greater than X1 implies that $F(X2)$ is less than or equal to $F(X1)$. In the example shown, the maximum allowed current 56 may be a step function. The switch unit 48 may be operable to check at any time t whether the current through the load 10 does not exceed the maximum allowed current 56. More specifically, the switch unit 48 may be operable to check continuously, quasi-continuously or intermittently whether the current through the load 10 is below the maximum allowed current 56. Intermittently may mean e.g. at least twice after first switching on the load 10. Quasi-continuously may mean at least once per period of the PWM control signal. Continuously may mean at every instant. The maximum allowed current 56, considered as a function of time, may be predefined. The predefined maximum allowed current may, for example, be adjustable via a serial peripheral interface (SPI). The maximum allowed current 56 may need to be adjusted, for example when the load 10 is replaced by another load (not shown) having different characteristics.

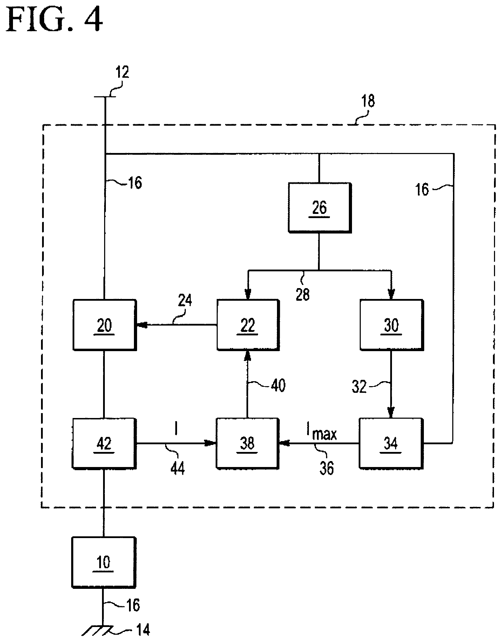

Referring now to Figure 4, an example of an embodiment of an overcurrent protection device 18 is shown. The overcurrent protection device 18 may include the features of the overcurrent protection device 18 described above in reference to Figure 2. The overcurrent protection device 18 may for example be an eXtreme switch, or comprise an extreme switch.

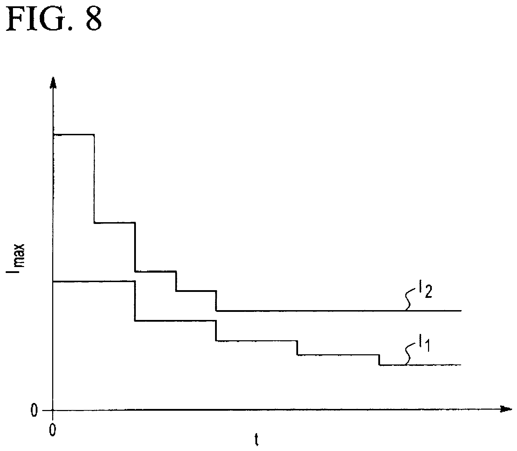

In the present example, overcurrent protection device 18 comprises a maximum-allowed-current unit 34 for determining a time-dependent maximum allowed current according to the supply voltage, and a power switch 20 having a conductive state and a nonconductive state. The power switch 20 may be arranged to assume the nonconductive state in response to an indication that a current through the power switch 20 is exceeding the maximum allowed current (e.g. one of the maximum allowed currents I1, I2 plotted in Figure 8). The maximum-allowed-current unit may thus adapt the maximum allowed current to variations of the supply voltage. This may render the overcurrent protection device 18 more reliable.

To this end, the overcurrent protection device 18 may comprise a current sensor 42 for determining a value of a current that is flowing through the power switch 20. The overcurrent protection device 18 may for example comprise an incandescent lamp 10 coupled in series with the power switch 20. For example, the maximum allowed current may be a monotonically increasing function of the supply voltage. The maximum allowed current may for example be proportional to the supply voltage. An embodiment of a maximum-allowed-current unit may comprise an analogue-to-digital converter for generating a digital value indicative of the supply voltage.

The overcurrent protection device may comprise a switch controller 22 for setting the power switch 20 alternatively into the conductive state and into the nonconductive state according to a pulse width modulated control signal 28. The overcurrent protection device 18 may further comprise a turn-on detector 30 for detecting a turn-on event. A turn-on event may comprise, for example: the pulse width modulated control signal 28 indicating, during an interval having a length of at least a minimum off-time, that the power switch 20 is to assume the nonconductive state, followed by the pulse width modulated control signal 28 indicating that the power switch 20 is to assume the conductive state. The maximum-allowed-current unit may be operable to determine the supply voltage in response to the turn-on detector 30 detecting a turn-on event. Alternatively or additionally, the maximum-allowed-current unit 34 may be operable to determine the maximum allowed current according to a real-time value of the supply voltage. Alternatively or additionally, the maximum-allowed-current unit 34 may be operable to determine the maximum allowed current as a function of an accumulated time during which the power switch 20 was in the conductive state. The maximum allowed current may for example be greater than an expected inrush current. For example, the maximum allowed current may be a monotonically decreasing function of time.

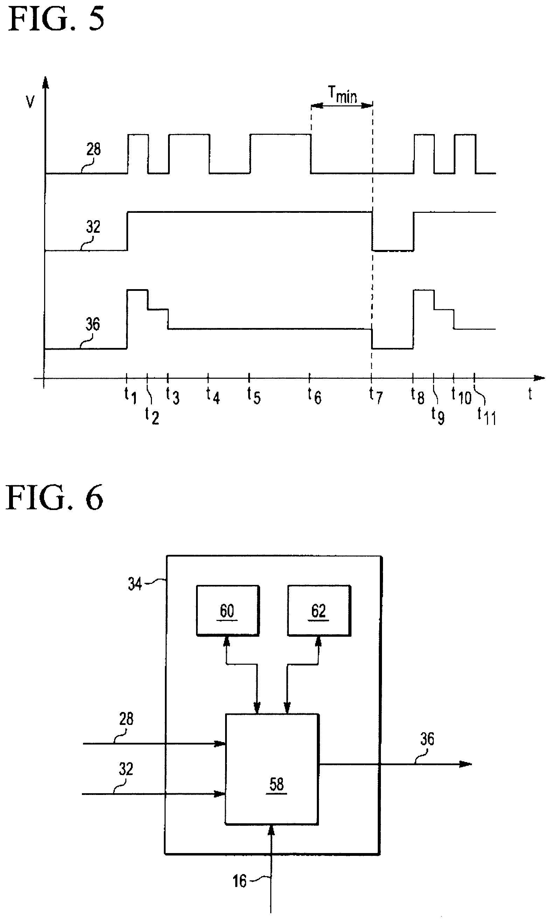

The overcurrent protection device 18 may comprise a timer for indicating a real time. A real time is understood to be the usual physical time relative to a suitable initial moment. The timer may, for example, be the timer 60 described in reference to Figure 6. The timer may have associated with it a predefined reset value. The reset value may for example be zero. The timer may for example be reset to the reset value in response to the turn-on detector 30 detecting a turn-on event. The maximum-current unit may thus be arranged to determine the maximum allowed current according to the real time.

The overcurrent protection device 18 may further comprise a pulse-width modulation unit 26 for defining a duty cycle according to the supply voltage, and for generating the pulse width modulated control signal 28 such that the pulse width modulated control signal 28 has the defined duty cycle. The duty cycle may, for example, be inversely proportional to the supply voltage.

In the shown example, the overcurrent protection device 18 is coupled in series with a load 10 between a first voltage provider 12 and a second voltage provider 14. Voltage providers 12, 14 may be arranged to provide a supply voltage. The overcurrent protection device 18 may comprise e.g. a conductor 16, a power switch 20, a switch controller 22, a PWM unit 26, a turn-on detector 30, a maximum-allowed-current unit 34, an comparator 38, and a current sensor 42. The conductor 16 may, for example, be of the kind described above in reference to Figure 2. Furthermore, the PWM unit 26 may, for example, be of the kind described above in reference to Figure 2. The same applies analogously to the voltage providers 12, 14 and the load 10.

The overcurrent protection device 18 may operate, for example, as follows. The PWM unit 26 may for example be responsive to an external signal (not shown) such as an user input signal for powering on/powering off the load 10. The PWM unit 26 may generate a PWM control signal 28. The PWM module 26 may adjust a duty cycle of the PWM control signal 28 according to a supply voltage. The supply voltage may, for example, be the voltage between the first voltage provider 12 and the second voltage provider 14. In the example, PWM unit 26 may sense the supply voltage via the conductor 16. The person skilled in the art will understand that the representation of conductors in the figure may be schematic and that each of the components of the overcurrent protection device 18 discussed herein may in fact be coupled to the first voltage provider 12 and/or the second voltage provider 14. The PWM control signal 28 may be fed to both the switch controller 22 and the turn-on detector 30.

In the present example, the turn-on detector 30 may evaluate the PWM control signal 28 to detect e.g. turn-on events and/or turn-off events. For example, the turn-on detector 30 may generate a turn-on detection signal 32 for indicating that a turn-on event has been detected. A turn-on event may, for example, be defined as the PWM control signal 28 indicating, during an interval having a length of at least a minimum off time, that the power switch 20 is to assume a nonconductive state, followed by the PWM control signal 28 indicating that the power switch 20 is to assume a conductive state. A turn-on event may correspond to time t=0 in Figure 3.

The maximum-allowed-current unit 34 may for example determine a maximum allowed current as function of time t, wherein the time t is measured from the turn-on event. Furthermore, the maximum-allowed-current unit 34 may determine the maximum allowed current (e.g. current 56 in Figure 3) not only according to a time, but also according to the supply voltage. The supply voltage may, for example, be the voltage provided by the conductor 16. The supply voltage may be defined, for example, relative to the second voltage provider 14, e.g. relative to ground. For example, the maximum-allowed-current unit may determine, for a given time t, the maximum allowed current as a function of the supply voltage at time t=0, that is, as a function of the supply voltage at the time of e.g. the turn-on event. For example, the maximum-allowed-current unit 34 may sense the supply voltage in response to the turn-on detector 30 detecting a turn-on event. Alternatively, the maximum-allowed-current unit 34 may, for example, determine a maximum allowed current according to a real time value of the supply voltage. In other words, the maximum-allowed-current unit 34 may, according to the latter example, determine the maximum allowed current as a function of both a time t and the supply voltage at the very same time t. The maximum-allowed-current unit 34 may generate a signal 36 that is indicative of the maximum allowed current. The maximum allowed current signal 36 may notably be a real time signal. For example, the maximum allowed current signal 36 may be indicative of the maximum allowed current at the time of generating the maximum allowed current signal. This may ensure that the maximum allowed current signal 36 may correlate with an actual current through the load 10.

The maximum allowed current signal 36 may be fed to the comparator 38. At the same time, the current sensor 42 may generate a current signal 44. The current signal 44 may be indicative of a current through the load 10, or, equivalently, through the power switch 20. For example, current signal 44 may be indicative of a momentary current through the load 10. The comparator 38 may determine whether the sensed current, as indicated by the current signal 44, does not exceed the maximum allowed current as indicated e.g. by the maximum allowed current signal 36. The comparator 38 may generate a comparison signal 40. Comparison signal 40 may indicate, for example, whether or not the sensed current is less than the maximum allowed current. For example, the comparator 38 may output TRUE (e.g. represented by a high voltage level) when the sensed current is less than the maximum allowed current, and FALSE (e.g. represented by a low voltage level) when the sensed current is greater than the maximum allowed current.

The PWM control signal 28 and the comparison signal 40 may for example be fed to the switch controller 22. The switch controller 22 may for example determine whether the power switch 20 is to be set into a conductive state or into a non-conductive state, based on the PWM control signal 28 and the comparison signal 40. The switch controller 22 may generate a switch control signal 24. The switch controller 22 may, for example, be an AND gate. In this case, the AND gate 22 may receive as input signals the PWM control signal 28 and the comparison signal 40 and output as output signal the switch control signal 24. The power switch 20 may assume, alternatively, its conductive and its non-conductive state as indicated by the switch control signal 24. For example, when the PWM control signal 28 and the comparison signal 40 both indicate TRUE, the switch controller 22 may output TRUE, for setting the power switch 20 into the conductive state. In contrast, when one or both of the PWM control signal 28 and the comparison signal 40 indicates FALSE, the switch controller 22 may output FALSE, for setting the power switch 20 into its non-conductive (isolating) state. The power switch 20 may for example be a transistor.

Referring now to Figure 5, examples of a PWM control signal 28, a turn-on detection signal 32, and a maximum allowed current signal 36 are plotted in a schematic and simplified manner. In the plot, the three signals 28, 32 and 36 are offset relative to each other along the vertical axis (the V axis) for the sake of clearness. The maximum allowed current signal 36 may depend on the turn-on detection signal 32. The turn-on detection signal 32 may depend on the PWM control signal 28. Each of these signals may be represented e.g. by a voltage V. For example, PWM control signal 28 may be represented by a voltage output by the PWM unit 26. The turn-on detection signal 32 may be represented by e.g. a voltage output by the turn-on detector 30. The maximum allowed current signal 36 may be represented by e.g. a voltage output by the maximum-allowed-current unit 34. In the example, any low-to-high transition (rising edge) in the PWM control signal 28 may trigger a corresponding rising edge in the turn-on detection signal 32. Rising edges in the PWM control signal 28 that occur while the turn-on detection signal 32 is high may have no effect on the turn-on detection signal 32. Any high-to-low transition (falling edge) in the PWM control signal 28 may trigger a falling edge in the turn-on detection signal 32 with a delay T_min, unless the falling edge in the PWM control signal 28 is followed by a rising edge within the defined delay T_min. The delay T_min may, for example, be 1.4 seconds. Thus a falling edge in the PWM control signal 28 may have no effect on the turn-on detection signal 32 if the falling edge is followed by a rising edge within the defined delay.

In the example, the PWM control signal 28 exhibits rising edges at times t1, t3, t5, t8, and t10 and falling edges at times t2, t4, t6, t9, and t11. In the example, the falling edges at t2, t4, and t9 have no effect on the turn-on detection signal 32 as they are respectively succeeded by rising edges at times t3, t5, and t10 within the defined delay. In the example, only the falling edge in the PWM control signal 28 at time t6 is not succeeded by a rising edge within the defined delay T_min. Accordingly, the falling edge in PWM control signal 28 at time t6 triggers a falling edge in the turn-on detection signal 32, namely, the falling edge at time t7. Time t7 is time t6 plus the delay, i.e. t7 = t6 + T_min. The rising edge in the PWM control signal 28 at time t8 then triggers the rising edge in the turn-on detection signal 32 at time t8. Rising edges and falling edges in the turn-on detection signal 32 may indicate turn-on and turn-off events, respectively. In the example, turn-on events are detected e.g. at times t1 and t8. A turn-off event is detected e.g. at t7.

Each detected turn-on event may trigger the maximum-allowed-current unit 34 to control a signal amplitude or a digital signal value (in the present example, a voltage) according to a predefined maximum allowed current profile. In this application, a current profile is a current considered as a function of time on an interval of interest. The maximum allowed current unit 34 may thus generate the maximum allowed current signal 36. The instant at which a turn-on event is detected may thus serve as the initial instant of the maximum allowed current profile (time t=0 in the example shown in Figure 3).

Figure 6 illustrates in a schematic and simplified manner an example embodiment of the maximum-allowed-current unit 34. The maximum-allowed-current unit 34 may, for example, be provided by a microcontroller or by dedicated circuitry. The maximum-allowed-current unit 34 may comprise a processor 58, a timer 60, and/or a memory 62. The memory 62 may for example contain data for enabling the processor 58 to determine the maximum allowed current as a function of time and supply voltage. In one embodiment, the data may comprise a maximum allowed current profile and instructions for enabling the processor 58 to scale the maximum allowed current profile as a function of a supply voltage value. For example, the data may include time scaling factors and/or amplitude scaling factors. In the same or in another embodiment, the data may comprise a look-up table for defining at least two different maximum allowed current profiles. The processor 58 may e.g. be arranged to select one of these profiles as a function of a supply voltage.

Determining a maximum allowed current may further involve an accumulated time. The accumulated time may be defined for example as a total time after a turn-on event during which the power switch 20 was in the conductive state. The accumulated time may thus be thought of as a time integral over the PWM control signal 28 starting at the most recent turn-on event. The idea behind this is that any period during which the power switch is in the non-conductive state may not contribute to a rise in temperature of the load 10. Any maximum allowed current profile may, therefore, be defined with respect to said accumulated time, rather than in respect to the real time t as shown in Figure 3. The processor 48 may, therefore, determine at any time t a corresponding accumulated time. From the accumulated time, the processor 58 may determine a maximum allowed current. The timer 60 may be reset in response to a detected turn-on event. For example, the timer 60 may further be set into a stop mode in response to a falling edge in the PWM control signal 28 and into a run mode in response to a rising edge in the PWM control signal 28. A stop mode is a mode in which the timer 60 is inactive. A run mode is a mode in which the timer 60 counts the physical time. The timer 60 may thus count the accumulated time.

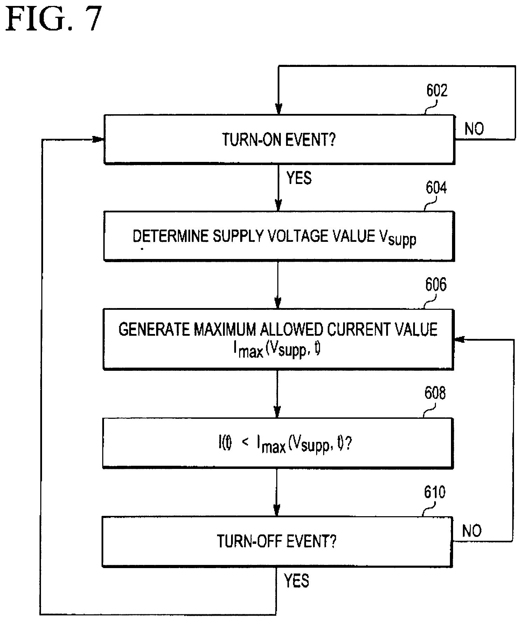

Thus, the maximum-allowed-current unit 34 may comprise a memory 62 containing data for defining the maximum allowed current as a function of at least a time variable and a supply voltage variable. For example, the maximum-allowed-current unit 34 may be operable to scale a maximum allowed current profile as a function of the supply voltage. The maximum-allowed-current unit 34 may notably be operable to scale the maximum allowed current profile in amplitude and/or in time. Referring now to Figure 7, a flow chart of an example of a method of operating a power switch is shown. The method according to the example comprises determining a maximum allowed current according to an applied supply voltage, and setting the power switch into the non-conductive state in response to an indication that a current through the power switch is exceeding the maximum allowed current. Determining the maximum allowed current may comprise detecting a turn-on event; and, in response thereto, determining the supply voltage.

In step 602, it may be determined whether a turn-on event has been detected. In this event, the process may continue with step 604; otherwise, the process may return to step 602.

In step 604, a value or amplitude of a supply voltage may be determined. This may involve measuring the supply voltage, e.g. using a voltage sensor.

In subsequent step 606, a maximum allowed current value may be generated on the basis of both the instantaneous time t and the supply voltage determined in the preceding step 604. Generating the maximum allowed current value may involve e.g. consulting a look-up table and/or determining an accumulated time, e.g. as described above in reference to Figure 6.

In subsequent step 608, it may be determined whether a current through the power switch is less than the maximum allowed current determined in previous step 606. If it is determined that the current through the power switch is greater than the maximum allowed current, the power switch may be set into a non-conductive state; otherwise no action may be taken.

In subsequent step 610, it may determined whether a turn-off event has been detected. If a turn-off event has been detected, the process may return to step 602; otherwise, the process may return to step 606. In another embodiment (not shown), the process may return to step 604 instead of step 606. In other words, the supply voltage may be determined in response to the turn-on event (as illustrated in Figure 7) or immediately before each step 606 of generating the maximum allowed current value. In practice, the supply voltage may be fairly constant over many turn-on/turn-off cycles. In this situation, it may be completely sufficient to determine the supply voltage only once after each turn-on event, as illustrated in the figure.

Referring now to Figure 8, a first maximum allowed current I1 and a second maximum allowed current I2 are plotted as functions of a time t in a schematic and simplified manner. The time t may be the usual physical time or an accumulated time as described above with reference to Figure 6. For example, the maximum-allowed-current unit 34 may generate either the first or the second maximum allowed current profile, that is either I1 or I2 depending on the supply voltage applied at the overcurrent protection device 18. The maximum allowed current protection unit 36 may, of course, be arranged to generate or select among more than two different maximum allowed current profiles. For example, maximum-allowed-current unit 34 may be arranged to generate or select among a continuous set of maximum allowed current profiles, e.g. using scaling factors. In the present example, I1 and I2 are related as follows:

$$I2(t) = A*I1(B*t)$$

where A is an amplitude scaling factor and B is a time scaling factor. In the example, A=2 and B=2. The maximum-allowed-current unit 34 may be arranged to determine the scaling factors according to the supply voltage. Thus, the scaling factors A and/or B may be functions of the supply voltage V. As mentioned above, the supply voltage V may for example be the supply voltage measured at a defined instant, e.g. after detecting a turn-on event, or the supply voltage measured in real-time.

The maximum allowed currents I1 and I2 may correspond to expected inrush currents. I1 and/or I2 may be offset relative to the respective inrush current by some fixed offset. Thus, it may be ensured that the actual current flowing through the power switch may always be less than the maximum allowed current during normal operation, i.e. if no failure or accident occurs. In the example, I2 corresponds to a greater supply voltage than I1. I2 may tend to its stationary value more rapidly because a higher supply voltage may imply that the temperature of the load rises more rapidly, assuming the same duty cycle.

More generally, the maximum-allowed-current unit 34 may be arranged to determine a maximum allowed current I_max(V,t) as a function of the supply voltage V and of a time t. Such determination may involve scaling factors, e.g. as described above with reference to Figure 8. However, the determination does not necessarily involve scaling factors. In particular, the maximum allowed current I_max(V,t) for a first voltage value V=V1 does not necessarily have to be related to the maximum allowed current I_max(V,t) for a different second voltage value V=V2. For example, the maximum-allowed-current unit 34 may be arranged to assign a maximum-allowed-current profile to each voltage value among a set of voltage values, e.g. using a look-up table.

Every physical quantity, such as a temperature, a voltage or a current, may be represented by a value or by a set of values. A voltage is a potential difference between two particular points at a given moment. A current is an amount of charge flowing through a particular cross section at a given moment.

In the foregoing specification, the invention has been described with reference to specific examples of embodiments of the invention. It will, however, be evident that various modifications and changes may be made therein without departing from the broader spirit and scope of the invention as set forth in the appended claims.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connections that transfers multiple signals serially or in a time multiplexed manner. Likewise, single connections carrying multiple signals may be separated out into various different connections carrying subsets of these signals. Therefore, many options exist for transferring signals.

Although specific conductivity types or polarity of potentials have been described in the examples, it will appreciated that conductivity types and polarities of potentials may be reversed.

Each signal described herein may be designed as positive or negative logic. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Furthermore, the terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality. For example, power switch 20 and switch controller 22 may be provided by an integrated circuit; and/or turn-on detector 30, maximum-allowed-current unit 34, and comparator 38 may be provided by an integrated circuit. PWM unit 26 may be integrated in the overcurrent protection device 18, or form a separate module. The entire overcurrent protection device 18 may be provided by an integrated circuit or a system on chip (SoC).

Any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected," or "operably coupled," to each other to achieve the desired functionality.

Furthermore, those skilled in the art will recognize that boundaries between the above described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments.

Also for example, in one embodiment, the illustrated examples may be implemented as circuitry located on a single integrated circuit or within a same device. For example, power switch 20 and switch controller 22 may be provided by an integrated circuit; and/or turn-on detector 30, maximum-allowed-current unit 34, and comparator 38 may be provided by an integrated circuit. PWM unit 26 may be integrated in the overcurrent protection device 18, or form a separate module. The entire overcurrent protection device 18 may be provided by an integrated circuit or a system on chip (SoC). Alternatively, the examples may be implemented as any number of separate integrated circuits or separate devices interconnected with each other in a suitable manner. For example, each of components 20, 22, 26, 30, 34, 38, 42 may be provided by a separate device.

Also for example, the examples, or portions thereof, may implemented as soft or code representations of physical circuitry or of logical representations convertible into physical circuitry, such as in a hardware description language of any appropriate type.

Also, the invention is not limited to physical devices or units implemented in non-programmable hardware but can also be applied in programmable devices or units able to perform the desired device functions by operating in accordance with suitable program code, such as mainframes, minicomputers, servers, workstations, personal computers, notepads, personal digital assistants, electronic games, automotive and other embedded systems, cell phones and various other wireless devices, commonly denoted in this application as 'computer systems'.

However, other modifications, variations and alternatives are also possible. The specifications and drawings are, accordingly, to be regarded in an illustrative rather than in a restrictive sense.

In the claims, any reference signs placed between parentheses shall not be construed as limiting the claim. The word 'comprising' does not exclude the presence of other elements or steps then those listed in a claim. Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

**Claims**

1. An overcurrent protection device (18), comprising a power switch (20) having a conductive state and a nonconductive state, a switch controller (22) for setting the power switch (20) into the conductive state and into the nonconductive state according to a pulse width modulated control signal (28), and a turn on-detector (30) for detecting a turn-on event, wherein a turn-on event comprises the pulse width modulated control signal (28) indicating, during an interval having a length of at least a minimum off-time, that the power switch (20) is to assume the nonconductive state, followed by the pulse width modulated control signal (28) indicating that the power switch (20) is to assume the conductive state; a maximum-allowed-current unit (34), for determining a time dependent maximum allowed current (I1; I2) wherein the power switch (20) is arranged to assume the nonconductive state in response to an indication that a current through the power switch (20) is exceeding the time dependent maximum allowed current (I1; I2), wherein the maximum-allowed-current unit (34) is configured to determine a supply voltage in response to the turn-on detector (30) detecting a turn-on event; and the maximum-allowed-current unit (34) is configured to determine the time dependent maximum allowed current (I1; I2), based on a current profile, as a function of an accumulated time, wherein the accumulated time is defined as a total time after a turn-on event during which the power switch (20) was in the conductive state, and the current profile is determined based on the supply voltage determined by the maximum-allowed-current unit in response to the turn-on event.

2. The overcurrent protection device (18) as set forth in claim 1, wherein the maximum-allowed-current unit (34) comprises a memory (62) containing data for defining the time dependent maximum allowed current (I1; I2) as a function of at least a time variable and a supply voltage variable.

3. The overcurrent protection device (18) as set forth in claim 2, wherein the data comprises a look-up table for defining at least two different maximum allowed current profiles and wherein the maximum-allowed-current unit (34) is operable to select one of the at least two maximum-allowed-current profiles as a function of the supply voltage.

4. The overcurrent protection device (18) as set forth in any one of the claims 1 or 2, wherein the maximum-allowed-current unit (34) is operable to scale the time dependent maximum allowed current profile in amplitude and/or in time.

5. The overcurrent protection device (18) as set forth in any one of the preceding claims, wherein the time dependent maximum allowed current is monotonically increasing function of the supply voltage.

6. The overcurrent protection device (18) as set forth in any one of the preceding claims, wherein the maximum-allowed-current unit (34) comprises an analogue-to-digital converter for generating a digital value indicative of the supply voltage.

7. The overcurrent protection device (18) as set forth in any one of the preceding claims, wherein the power switch (20) is arranged to assume the nonconductive state in response to the pulse width modulated control signal (28) being at a first level and the conductive state in response to the pulse width modulated control signal (28) being at a second level, and wherein a turn-on event comprises
the pulse width modulated control signal (28) being at the first level during an interval having a length of at least a minimum off-time, followed by
the pulse width modulated control signal (28) being at the second level.

8. The overcurrent protection device (18) as set forth in any one of the preceding claims, comprising a pulse-width modulation unit (26) for defining a duty cycle according to the supply voltage, and for generating the pulse width modulated control signal (28) such that the pulse width modulated control signal 28) has the defined duty cycle.

9. The overcurrent protection device (18) as set forth in any one of the preceding claims, comprising an incandescent lamp (10) coupled in series with the power switch (20).

10. A method of operating a power switch (20), wherein the power switch (20) has a conductive state and a nonconductive state and wherein the method comprises
setting the power switch (20) into the conductive state and into the nonconductive state according to a pulse width modulated control signal (28);
detecting a turn-on event, wherein a turn-on event comprises the pulse width modulated control signal (28) indicating, during an interval having a length of at least a minimum off-time, that the power switch (20) is to assume the nonconductive state, followed by the pulse width modulated control signal (28) indicating that the power switch (20) is to assume the conductive state;
setting the power switch (20) into the nonconductive state in response to an indication that a current through the power switch (20) is exceeding a maximum allowed current, determining a supply voltage in response to detecting a turn-on event; and
determining the maximum allowed current based on a current profile as a function of an accumulated time, the current profile comprising a function of accumulated time on an interval of interest, wherein the accumulated time is defined as a total time after a turn-on event during which the power switch (20) was in the conductive state, and determining the current profile based on the supply voltage determined in response to detecting a turn-on event.

**Patentansprüche**

1. Eine Überstromschutzvorrichtung (18), aufweisend:

einen Leistungsschalter (20), der einen leitenden und einen nicht leitenden Zustand aufweist,
eine Schaltersteuerungseinrichtung (22) zum Stellen des Leistungsschalters (20) in den leitenden Zustand und in den nicht leitenden Zustand gemäß einem impulsbreitemodulierten Steuerungssignal (28), und
einen Einschaltdetektor (30) zum Detektieren eines Einschaltereignisses, wobei ein Einschaltereignis umfasst, dass das impulsbreitemodulierte Steuerungssignal (28) während eines Intervalls mit einer Länge von mindestens einer minimalen Aus-Zeit angibt, dass der Leistungsschalter (20) den nicht leitenden Zustand einnehmen soll, gefolgt davon, dass das impulsbreitemodulierte Steuerungssignal (28) angibt, dass der Leistungsschalter (20) den leitenden Zustand einnehmen soll,
eine Erlaubter-Maximalstrom-Einheit (34) zum Bestimmen eines zeitabhängigen, erlaubten Maximalstroms (|1; |2),
wobei der Leistungsschalter (20) dazu ausgebildet ist, den nicht leitenden Zustand einzunehmen in Antwort auf ein Anzeichen dafür, dass ein Strom durch den Leistungsschalter (20) den zeitabhängigen, erlaubten Maximalstrom (|1; |2) überschreitet,
wobei die Erlaubter-Maximalstrom-Einheit (34) dazu eingerichtet ist, eine Versorgungsspannung zu bestimmen in Antwort darauf, dass der Einschaltdetektor (30) ein Einschaltereignis detektiert, und
die Erlaubter-Maximalstrom-Einheit (34) dazu eingerichtet ist, den zeitabhängigen, erlaubten Maximalstrom (|1; |2) zu bestimmen auf der Grundlage eines Stromprofils in Abhängigkeit von einer akkumulierten Zeit, wobei die akkumulierte Zeit definiert ist als eine Gesamtzeit nach einem Einschaltereignis, während dessen der Leistungsschalter (20) in dem leitenden Zustand war, und das Stromprofil bestimmt wird auf der Grundlage von der von der Erlaubter-Maximalstrom-Einheit (34) in Antwort auf das Einschaltereignis bestimmten Versorgungsspannung.

2. Die Überstromschutzvorrichtung (18) gemäß Anspruch 1, wobei die Erlaubter-Maximalstrom-Einheit (34) einen Datenspeicher (62) aufweist, der Daten zum Definieren des zeitabhängigen, erlaubten Maximalstroms (|1; |2) in Abhängigkeit von mindestens einer Zeitvariablen und einer Versorgungsspannungsvariablen enthält.

**3.** Die Überstromschutzvorrichtung (18) gemäß Anspruch 2, wobei die Daten eine Nachschlagetabelle zum Definieren von mindestens zwei verschiedenen, erlaubten Maximalstromprofilen aufweisen und wobei die Erlaubter-Maximalstrom-Einheit (34) betriebsfähig dafür ist, eines von den mindestens zwei verschiedenen, erlaubten Maximalstromprofilen in Abhängigkeit von der Versorgungsspannung auszuwählen.

**4.** Die Überstromschutzvorrichtung (18) gemäß einem der Ansprüche 1 oder 2, wobei die Erlaubter-Maximalstrom-Einheit (34) betriebsfähig dafür ist, das zeitabhängige, erlaubte Maximalstromprofil hinsichtlich der Amplitude und/oder hinsichtlich der Zeit zu skalieren.

**5.** Die Überstromschutzvorrichtung (18) gemäß einem der vorhergehenden Ansprüche, wobei der zeitabhängige, erlaubte Maximalstrom eine monoton steigende Funktion der Versorgungsspannung ist.

**6.** Die Überstromschutzvorrichtung (18) gemäß einem der vorhergehenden Ansprüche, wobei die Erlaubter-Maximalstrom-Einheit (34) einen Analog-Digital-Wandler zum Erzeugen eines digitalen Werts, der für die Versorgungsspannung indikativ ist, aufweist.

**7.** Die Überstromschutzvorrichtung (18) gemäß einem der vorhergehenden Ansprüche, wobei der Leistungsschalter (20) dazu ausgebildet ist, den nicht leitenden Zustand anzunehmen in Antwort darauf, dass das impulsbreitemodulierte Steuerungssignal (28) auf einem ersten Niveau ist, und den leitenden Zustand anzunehmen in Antwort darauf, dass das impulsbreitemodulierte Steuerungssignal (28) auf einem zweiten Niveau ist, und wobei ein Einschaltereignis umfasst,
dass das impulsbreitemodulierte Steuerungssignal (28) während eines Intervalls, das eine Länge von mindestens einer minimalen Aus-Zeit aufweist, auf dem ersten Niveau ist, gefolgt davon,
dass das impulsbreitemodulierte Steuerungssignal (28) auf dem zweiten Niveau ist.

**8.** Die Überstromschutzvorrichtung (18) gemäß einem der vorhergehenden Ansprüche, aufweisend eine Impulsbreitemodulationseinheit (26) zum Definieren einer Einschaltdauer gemäß der Versorgungsspannung und zum Erzeugen des impulsbreitemodulierten Steuerungssignals (28) so, dass das impulsbreitemodulierte Steuerungssignal (28) die definierte Einschaltdauer aufweist.

**9.** Die Überstromschutzvorrichtung (18) gemäß einem der vorhergehenden Ansprüche, aufweisend eine Glühlampe (10), die in Reihe mit dem Leistungsschalter (20) gekoppelt ist.

**10.** Ein Verfahren zum Betreiben eines Leistungsschalters (20), wobei der Leistungsschalter (20) einen leitenden Zustand und einen nicht leitenden Zustand aufweist, und wobei das Verfahren aufweist:

Stellen des Leistungsschalters (20) in den leitenden Zustand und in den nicht leitenden Zustand gemäß einem impulsbreitemodulierten Steuerungssignal (28),
Detektieren eines Einschaltereignisses, wobei ein Einschaltereignis umfasst, dass das impulsbreitemodulierte Steuerungssignal (28) während eines Intervalls mit einer Länge von mindestens einer minimalen Aus-Zeit angibt, dass der Leistungsschalter (20) den nicht leitenden Zustand einnehmen soll, gefolgt davon, dass das impulsbreitemodulierte Steuerungssignal (28) angibt, dass der Leistungsschalter (20) den leitenden Zustand einnehmen soll,
Stellen des Leistungsschalters (20) in den nicht leitenden Zustand in Antwort auf ein Anzeichen dafür, dass ein Strom durch den Leistungsschalter (20) einen erlaubten Maximalstrom überschreitet,
Bestimmen einer Versorgungsspannung in Antwort auf ein Detektieren eines Einschaltereignisses,
Bestimmen des erlaubten Maximalstroms auf der Grundlage eines Stromprofils in Abhängigkeit von einer akkumulierten Zeit, wobei das Stromprofil eine Funktion einer akkumulierten Zeit auf einem von Interesse seienden Intervall aufweist, wobei die akkumulierte Zeit definiert ist als eine Gesamtzeit nach einem Einschaltereignis, während dessen der Leistungsschalter (20) in dem leitenden Zustand war, und
Bestimmen des Stromprofils auf der Grundlage von der in Antwort auf das Detektieren eines Einschaltereignisses bestimmten Versorgungsspannung.

**Revendications**

**1.** Dispositif de protection de surintensités (18), comprenant :

un commutateur d'énergie (20) ayant un état conducteur et un état non conducteur,
un contrôleur de commutateur (22) pour mettre le commutateur d'énergie (20) dans l'état conducteur et dans l'état non conducteur en fonction d'un signal de contrôle modulé en largeur d'impulsions (28), et
un détecteur de mise en circuit (30) pour détecter un événement de mise en circuit, cas dans lequel un événement de mise en circuit comprend le signal de contrôle modulé en largeur d'impulsions (28) indiquant, durant un intervalle ayant une longueur d'au moins une durée d'inactivité minimum, que le commutateur d'énergie (20) doit adopter l'état non conducteur, suivi du signal de contrôle modulé en largeur d'impulsions (28) indiquant que le commutateur d'énergie (20) doit adopter l'état conducteur ;
une unité à courant admissible maximum (34), pour déterminer un courant admissible maximum dépendant du temps (I1 ; I2),
cas dans lequel le commutateur d'énergie (20) est agencé de façon à adopter l'état non conducteur en réaction à une indication qu'un courant passant à travers le commutateur d'énergie (20) dépasse le courant admissible maximum dépendant du temps (I1 ; I2),
cas dans lequel l'unité à courant admissible maximum (34) est configurée de façon à déterminer une tension d'alimentation en réaction au fait que le détecteur de mise en circuit (30) détecte un événement de mise en circuit ; et l'unité à courant admissible maximum (34) est configurée de façon à déterminer le courant admissible maximum dépendant du temps (I1 ; I2), sur la base d'un profil de courant, en tant que fonction d'un temps accumulé, cas dans lequel le temps accumulé est défini en tant que temps total après un événement de mise en circuit durant lequel le commutateur d'énergie (20) était dans l'état conducteur, et le profil de courant est déterminé sur la base de la tension d'alimentation déterminée par l'unité à courant admissible maximum en réaction à l'événement de mise en circuit.

2. Dispositif de protection de surintensités (18) tel qu'énoncé dans la revendication 1, l'unité à courant admissible maximum (34) comprenant une mémoire (62) laquelle contient des données pour définir le courant admissible maximum dépendant du temps (I1 ; I2) en fonction d'au moins une variable temporelle et d'une variable de la tension d'alimentation.

3. Dispositif de protection de surintensités (18) tel qu'énoncé dans la revendication 2, les données comprenant une table de consultation pour définir au moins deux profils de courant admissible maximum différents, et l'unité à courant admissible maximum (34) étant apte à fonctionner pour sélectionner un profil parmi lesdits au moins deux profils de courant admissible maximum en tant que fonction de la tension d'alimentation.

4. Dispositif de protection de surintensités (18) tel qu'énoncé dans l'une quelconque des revendications 1 ou 2, l'unité à courant admissible maximum (34) étant apte à fonctionner pour mettre à l'échelle le profil de courant admissible maximum dépendant du temps en amplitude et/ou en temps.

5. Dispositif de protection de surintensités (18) tel qu'énoncé dans l'une quelconque des revendications précédentes, le courant admissible maximum dépendant du temps étant une fonction à augmentation monotone de la tension d'alimentation.

6. Dispositif de protection de surintensités (18) tel qu'énoncé dans l'une quelconque des revendications précédentes, l'unité à courant admissible maximum (34) comprenant un convertisseur analogique/numérique pour générer une valeur numérique indicative de la tension d'alimentation.

7. Dispositif de protection de surintensités (18) tel qu'énoncé dans l'une quelconque des revendications précédentes, le commutateur d'énergie (20) étant agencé de façon à adopter l'état non conducteur en réaction au fait que le signal de contrôle modulé en largeur d'impulsions (28) se trouve à un premier niveau, et l'état conducteur en réaction au fait que le signal de contrôle modulé en largeur d'impulsions (28) se trouve à un deuxième niveau, et cas dans lequel un événement de mise en circuit comprend
le fait que le signal de contrôle modulé en largeur d'impulsions (28) se trouve au premier niveau durant un intervalle ayant une longueur d'au moins une durée d'inactivité minimum, suivi du fait que
le signal de contrôle modulé en largeur d'impulsions (28) qui se trouve au deuxième niveau.

8. Dispositif de protection de surintensités (18) tel qu'énoncé dans l'une quelconque des revendications précédentes, comprenant une unité de modulation d'impulsions en largeur (26) pour définir un cycle de service en fonction de la tension d'alimentation, et pour générer le signal de contrôle modulé en largeur d'impulsions (28) de telle sorte que le signal de contrôle modulé en largeur d'impulsions (28) ait le cycle de service défini.

9. Dispositif de protection de surintensités (18) tel qu'énoncé dans l'une quelconque des revendications précédentes, comprenant une lampe à incandescence (10) couplée en série avec le commutateur d'alimentation (20).

10. Procédé de fonctionnement d'un commutateur d'énergie (20), le commutateur d'énergie (20) ayant un état conducteur et un état non conducteur, et le procédé comprenant les opérations consistant à :

mettre le commutateur d'énergie (20) dans l'état conducteur et dans l'état non conducteur en fonction d'un signal de contrôle modulé en largeur d'impulsions (28) ;
détecter un événement de mise en circuit, cas dans lequel un événement de mise en circuit comprend le signal de contrôle modulé en largeur d'impulsions (28) indiquant, durant un intervalle ayant une longueur d'au moins une durée d'inactivité minimum, que le commutateur d'énergie (20) doit adopter l'état non conducteur, suivi du signal de contrôle modulé en largeur d'impulsions (28) indiquant que le commutateur d'énergie (20) doit adopter l'état conducteur ;
mettre le commutateur d'énergie (20) dans l'état non conducteur en réaction à une indication qu'un courant passant à travers le commutateur d'énergie (20) dépasse un courant admissible maximum,
déterminer une tension d'alimentation en réaction à la détection d'un événement de mise en circuit ; et
déterminer le courant admissible maximum sur la base d'un profil de courant en tant que fonction d'un temps accumulé, le profil de courant comprenant une fonction de temps accumulé sur un intervalle d'intérêt, cas dans lequel le temps accumulé est défini en tant que temps total après un événement de mise en circuit durant lequel le commutateur d'énergie (20) était dans l'état conducteur, et déterminer le profil de courant sur la base de la tension d'alimentation déterminée en réaction à la détection d'un événement de mise en circuit.

# FIG. 1
- PRIOR ART -

# FIG. 2
- PRIOR ART -

# FIG. 3
- PRIOR ART -

# FIG. 4

# FIG. 5

# FIG. 6

# FIG. 7

TURN-ON EVENT? — 602 — NO

YES

DETERMINE SUPPLY VOLTAGE VALUE $V_{supp}$ — 604

GENERATE MAXIMUM ALLOWED CURRENT VALUE $I_{max}(V_{supp}, t)$ — 606

$I(t) < I_{max}(V_{supp}, t)$? — 608

TURN-OFF EVENT? — 610 — NO

YES

# FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006111187 A1, Turpin
- US 2003072120 A1, Ishikawa
- WO 2010012323 A1